# EUROPEAN PATENT APPLICATION

(11) **EP 1 114 697 A2**
(43) Date of publication of application: **11.07.2001**
(21) Application number: 00311062.4
(22) Date of filing: 12.12.2000
(51) Int. Cl.: B24D 13/12, B24D 13/14, B24B 37/04, B24B 57/02

(54) **Apparatus and method for controlled delivery of slurry to a region of a polishing device**

(30) Priority: 13.12.1999 US 170596 P
(71) Applicant: Applied Materials, Inc., Santa Clara, California 95054 (US)
(72) Inventor: Chen, Hung, San Jose,CA 95131 (US); Huey, Sidney P., Milpitas,CA 95035 (US)
(74) Representative: Draper, Martyn John

(57) **Abstract**

A polishing pad and/or platen for use in a chemical mechanical polishing system is provided. The polishing pad and/or platen have slurry distribution/retaining grooves formed on a surface thereof. In one embodiment, the grooves are formed on the upper polishing surface of a pad for use in a rotary or linear polishing system. In another embodiment, an upper mounting surface of a platen is patterned with grooves. The grooves are adapted to direct the flow of slurry inwardly from a perimeter portion of the pad/platen. In operation, the grooves provide uniform distribution of slurry to areas on a polishing pad/platen.

## Description

The present invention relates to an apparatus and method for polishing substrates. More particularly, the invention relates to a platen/polishing pad assembly having a patterned surface to control the delivery of slurry onto a polishing surface of a pad.

In the fabrication of integrated circuits and other electronic devices, multiple layers of conducting, semiconducting and dielectric materials are deposited and removed from a substrate during the fabrication process. Often it is necessary to polish a surface of a substrate to remove high topography, surface defects, scratches or embedded particles. One polishing process is known as chemical mechanical polishing (CMP) and is used to improve the quality and reliability of the electronic devices formed on the substrate.

Typically, the polishing process involves the introduction of a chemical slurry onto a polishing pad during the polishing process to facilitate higher removal rates and selectivity between films on the substrate surface. In general, the polishing process involves holding a substrate against a polishing pad under controlled pressure, temperature and rotational velocity of the pad in the presence of the slurry or other fluid medium. One polishing system that is used to perform CMP is the MIRRA System available from Applied Materials, Inc., and shown and described in U.S. Patent No. 5,738,574, entitled, "Continuous Processing System for Chemical Mechanical Polishing," the entirety of which is incorporated herein by reference.

An important goal of CMP is achieving uniform planarity of the substrate surface. Uniform planarity includes the uniform removal of material from the surface of substrates as well as removing non-uniform layers which have been deposited on the substrate. Successful CMP also requires process repeatability from one substrate to the next. Thus, uniformity must be achieved not only for a single substrate, but also for a series of substrates processed in a batch.

Substrate planarity is dictated, to a large extent, by the construction of the CMP apparatus and the composition and construction of the consumables such as the slurry and the pads all of which contribute to the polishing rate. One factor which contributes to the unpredictability and non-uniformity of the polishing of the chemical mechanical polishing process is the non-homogeneous replenishment and distribution of slurry at the interface of the substrate and the polishing pad. The slurry is primarily used to enhance the material removal rate of selected materials from the substrate surface. As a fixed volume of slurry in contact with the substrate reacts with the selected materials on the substrate surface, the slurry constituents are consumed. Accordingly, the slurry becomes less reactive and the polishing enhancing characteristics of the slurry are significantly reduced. Further, because the edge of the substrate contacts the slurry prior to the center of the substrate, the slurry reaching the center is less reactive than the fresh slurry supplied to the edge. Thus, the removal rate of material over the surface of the substrate is non-uniform and typically results in center-slow polishing. Attempting to compensate for the center-slow polishing effect by increasing the pressure applied to the center portion of the substrate compromises the planarity of the substrate.

One approach to overcoming the problem of replenishment of fresh slurry to all areas of the substrate is to continuously provide fresh slurry onto the polishing pad. However, because of the physical configuration of the polishing apparatus, introducing fresh slurry into the area of contact between the substrate and the polishing pad is difficult, and providing a consistently fresh supply of slurry to all portions of the substrate and the polishing pad is even more difficult. As a result, the uniformity and overall rate of polishing are significantly affected as the slurry reacts with the substrate.

Another problem with continuously providing fresh slurry onto the polishing pad is the volume of slurry that is consumed. In order to minimize the cost of operation, the volume of slurry used in a processing cycle should be minimized. However, conventional pads are not capable of efficiently retaining the slurry between the pad and the substrate. The inertia of the slurry during the rotation of the pad causes the slurry to flow off of the pad during operation. Thus, conventional practice dictates continuously providing fresh slurry onto the polishing pad. As a result, the volume of consumed slurry is substantially higher than is desirable.

One solution to remedy the problem of poor slurry distribution has been to provide grooves in the pad. One grooved pad is the IC 1000 pad available from Rodel, Inc., of Newark, Delaware. The grooves of the IC 1000 pad are in an X-Y configuration in the upper polishing surface of the pad and are believed to control the distribution of the slurry during operation by retaining a portion of the slurry in the grooves. However, while such pad designs accommodate more slurry volume, the pads have proved inefficient because the slurry flows radially outward and off of the pad during rotation of the pad. As a result, conventional polishing pads continue to consume large volumes of slurry, thereby substantially increasing the cost of operation.

Therefore, there is a need for a polishing pad capable of controlling slurry distribution over the pad surface and providing uniform and planar polishing.

The present invention generally provides an apparatus for polishing a substrate which improves the distribution of slurry over the surface of a polishing pad and improves uniformity and planarity of the polishing process. In one embodiment, the apparatus is adapted for incorporation into a chemical mechanical polishing system.

In one aspect of the invention, a polishing pad is provided having an upper polishing surface and a lower mounting surface. A plurality of fluid delivery grooves is formed in at least one of the surfaces. The grooves are adapted to control the distribution of fluid during movement of the pad.

In another aspect of the invention, a platen is provided comprising a patterned surface for mounting a polishing pad thereon. The patterned surface is defined by a plurality of grooves formed on the surface which are adapted to control the distribution of fluid during movement of the platen. In one embodiment, a pad may be disposed on the patterned surface. Delivery of fluid to an upper polishing surface of the pad is facilitated by pores formed in the pad which couple the grooves to the upper surface of the pad.

In another aspect of the invention, the delivery of slurry is controlled to provide a greater volume of slurry to a desired location on the pad. During rotation of the pad, a patterned surface of a pad or platen is adapted to induce the slurry to flow inwardly away from an edge of the pad or platen.

So that the manner in which the above recited embodiments and features of the present invention are attained and can be understood in detail, a more particular description of the invention, briefly summarized above, may be had by reference to the embodiments thereof which are illustrated in the appended drawings.

Figure 1 is a schematic view of a CMP system.

Figure 2 is a schematic view of a polishing station.

Figure 3 is a top view of one embodiment of a polishing pad.

Figure 4 is a top view of another embodiment of a polishing pad.

Figure 5 is a top view of another embodiment of a polishing pad.

Figure 6 is a top view of another embodiment of a polishing pad.

Figure 7 is a top view of another embodiment of a polishing pad.

Figure 8 is a top view of a polishing pad for use with a linear drive system.

Figure 9 is a cross sectional view of a polishing pad taken along the width of a groove formed in the pad.

Figure 10 is a cross sectional view of a polishing pad taken along the length of a sloped groove formed in the pad.

Figure 11 is a partial perspective view of a platen and a pad disposed on the platen, wherein the pad has a patterned lower surface.

Figure 12 is a partial perspective view of a platen having a patterned surface and a pad disposed on the platen.

The present invention generally relates to a polishing pad and/or a platen having slurry distribution/retaining grooves formed thereon. In one embodiment, the grooves are formed on the upper polishing surface of a pad for use in a rotary or linear polishing system. In another embodiment, an upper mounting surface of a platen is patterned with grooves. The grooves are adapted to direct the flow of slurry inwardly from a perimeter portion of the pad/platen. In operation, the grooves formed in the pad/platen provide controlled distribution of slurry. In one aspect, a relatively higher volume of slurry may be provided to desired areas of the pad to facilitate a higher removal rate of material from a substrate at those areas or more uniform removal rate of material across the surface of a substrate.

For clarity and ease of description, the following description refers primarily to a CMP system. However, the invention is equally applicable to other types of processes that utilize a pad for polishing or cleaning a substrate.

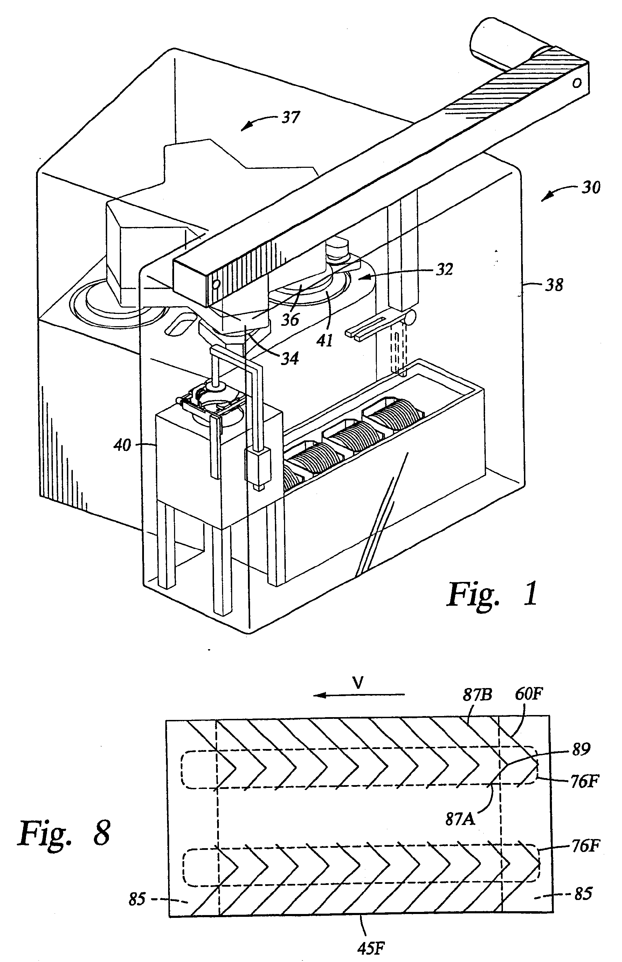

Figure 1 is a schematic view of a CMP system 30, such as a MIRRA System available from Applied Materials, Inc., located in Santa Clara, California. The system 30 includes three polishing stations 32 and a loading station 34. Four polishing heads 36 are rotatably mounted to a polishing head displacement mechanism 37 disposed above the polishing stations 32 and the loading station 34. A front-end substrate transfer region 38 is disposed adjacent to the CMP system and is considered a part of the CMP system, though the transfer region 38 may be a separate component. A substrate inspection station 40 is disposed in the substrate transfer region 38 to enable pre and/or post process inspection of substrates introduced into the system 30.

Typically, a substrate is loaded on a polishing head 36 at the loading station 34 and is then rotated through the three polishing stations 32. The polishing stations 32 each comprise a rotating platen 41 having polishing or cleaning pads mounted thereon. One process sequence includes a polishing pad at the first two stations and a cleaning pad at the third station to facilitate substrate cleaning at the end of the polishing process. At the end of the cycle, the substrate is returned to the front-end substrate transfer region 38 and another substrate is retrieved from the loading station 34 for processing.

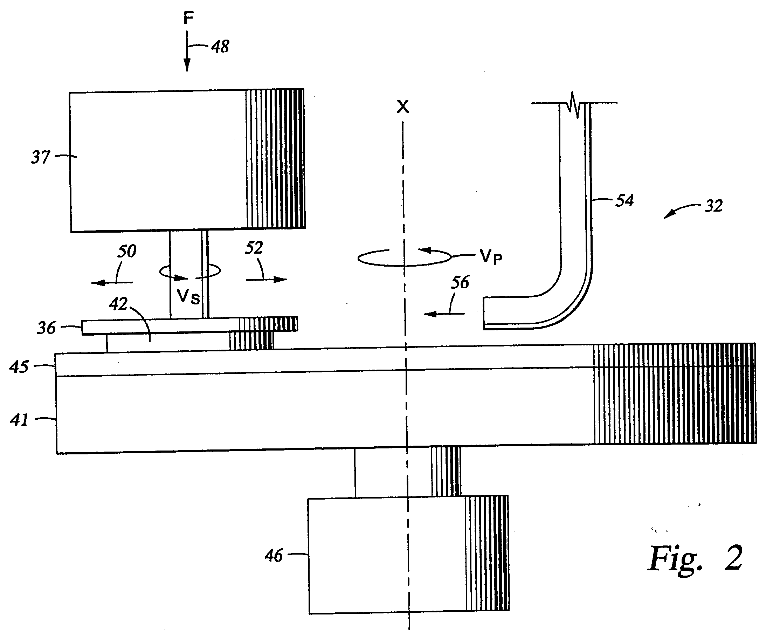

Figure 2 is a schematic view of a polishing station 32 and polishing head 36 used to advantage with the present invention. The polishing station 32 comprises a pad 45 secured to an upper surface of a rotatable platen 41. The pad 45 is preferably made of a plastic or foam such as polyurethane, but other materials known and unknown may be used. Although shown here as a single layer pad, it is understood that in other embodiments the pad may be a composite pad comprising multiple layers. The platen 41 is coupled to a motor 46 or other suitable drive mechanism to impart rotational movement to the platen 41. During operation, the platen 41 is rotated at a velocity Vₚ about a center axis X. The platen 41 can be rotated in either a clockwise or counterclockwise direction.

Figure 2 also shows the polishing head 36 mounted above the polishing station 32. The polishing head 36 supports a substrate 42 for polishing. The polishing head 36 may comprise a vacuum-type mechanism to chuck the substrate 42 against the polishing head 36. During operation, the vacuum chuck generates a negative vacuum force behind the surface of the substrate 42 to attract and hold the substrate 42. The polishing head 36 typically includes a pocket (not shown) in which the substrate 42 is supported, at least initially, under vacuum. Once the substrate 42 is secured in the pocket and positioned on the pad 45, the vacuum can be removed. The polishing head 36 then applies a controlled pressure behind the substrate, indicated by the arrow 48, to the backside of the substrate 42 urging the substrate 42 against the pad 45 to facilitate polishing of the substrate surface. The polishing head displacement mechanism 37 rotates the polishing head 36 and the substrate 42 at a velocity Vₛ in a clockwise or counterclockwise direction, preferably the same direction as the platen 41. The polishing head displacement mechanism 37 also preferably moves the polishing head 36 radially across the platen 41 in a direction indicated by arrows 50 and 52.

With reference to Figure 2, the CMP system also includes a chemical supply system 54 for introducing a chemical slurry of a desired composition to the polishing pad 45. In some applications, the slurry provides an abrasive material which facilitates the polishing of the substrate surface, and is preferably a composition formed of solid alumina or silica. During operation, the chemical supply system 54 introduces the slurry, as indicated by arrow 56, on the pad 45 at a selected rate. In other applications the pad 45 may have abrasive particles disposed thereon and require only that a liquid, such as deionized water, be delivered to the polishing surface of the pad 45.

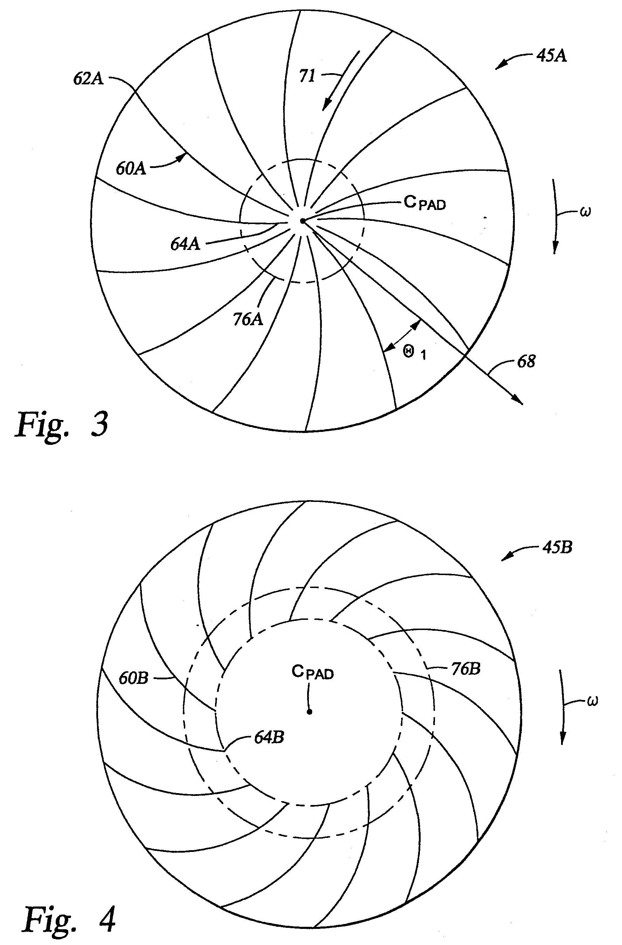

In one embodiment, the invention provides a patterned polishing surface of the pad 45 for controlling the flow of a fluid such as slurry or deionized water. Figure 3 show a top view of one embodiment of a polishing pad 45A having a patterned surface formed thereon. The patterned surface is defined by a plurality of equally spaced fluid distribution/retaining grooves 60 formed in the polishing surface of the pad 45A. The grooves 60A are arcuate, or tubine-shaped, and extend from an initial end 62A at the edge of the pad 45A to a terminal end 64A near the center C_{Pad} of the pad 45A. In the embodiment of Figure 3, the grooves 60A are not sealed, or blocked, at the initial end 62A. Such an embodiment facilitates construction of the grooves 60A which are milled out by conventional methods such as by a milling bit. However, the grooves 60A can be sealed at their respective initial ends 62A. Further, the grooves may be formed by alternative methods such as molding the pad 45 with cast having the desired pattern.

The grooves 60A are oriented and shaped to facilitate fluid flow from the initial end 62A inwardly to the terminal end 64A. The grooves 60A are formed in the pad 45A so that when the pad 45A is rotated in the direction ω, slurry is flowed toward the center C_{pad} as indicated by the arrow 71. That is, moving along the length of the grooves 60A from the terminal end 64A to the initial end 62A, the grooves 60A are curved in a clockwise direction which corresponds to the direction of rotation ω. Further, a radial line 68 originating at the center C_{pad} of the pad 45A indicates that no point of the grooves 60A is tangent to the radial line 68 except the terminal ends 64A. The curvature of the grooves 60A is indicated by an angle θ₁ which is defined by the angular relation between the radial line 68 and a tangent point on the groove 60A. As shown in Figure 3, θ₁ decreases moving inward along the grooves 60A toward center C_{pad}.

In general, θ₁ is selected to cause fluid flow through the grooves 60A during rotation of the pad 45A. During rotation, fluid from the chemical supply system 54 is "scooped up" and flowed through the grooves 60A inwardly toward C_{pad} in the direction of arrow 71. As the curvature of the grooves 60A approaches a point tangent to radial line 68, the fluid decreasingly experiences the necessary force to flow the fluid inward toward the terminal end 64A. The rate at which fluid is flowed through the grooves is generally dependent on the radial position of the fluid on the pad 45A, the angular velocity of the pad 45A, the viscosity of the fluid, and θ₁. Persons skilled in the art will empirically determine optimal values for these and other parameters.

The slung initially collects at a point along the length of the grooves 60A until sufficient pressure accumulates to flow the slurry out of the grooves 60A and onto the upper surface of the pad 45A.

The grooves 60A shown in the embodiment of Figure 3 are constructed to supply slurry toward a central collection area 76A (represented by dashed lines) of the pad 45A. The slurry collection area 76A is defined by that area of the pad 45A where a relatively increased volume of slurry is delivered due to the presence of the slurry distribution grooves 60A. The slurry collection area 76A may be determined by the position of the terminal end 64A or where the slurry is forced onto the upper surface of the pad due to accumulation of the slurry in the grooves 60A (e.g., where the grooves 60A are tangent to the radial line 68). Thus, in Figure 3 the slurry flows through the grooves 60A and then onto the upper polishing surface of the pad 45A at the terminal ends 64A during operation.

Figure 4 shows another embodiment of a pad 45B having grooves 60B similar to grooves 60A of Figure 3 except that the terminal ends 64B are positioned further radially outwardly from the center C_{pad} of the pad 45B. Accordingly, the slurry collection area 76B (shown by dashed lines) is an annular region substantially commensurate with the positioning of the terminal ends 64B.

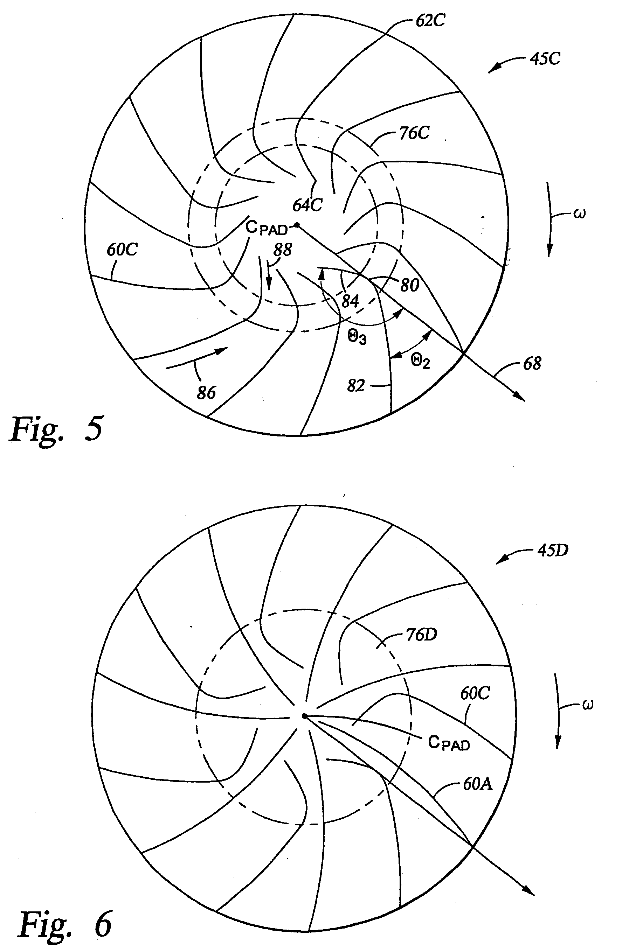

Another embodiment, shown in Figure 5, provides an example of grooves 60C having the same direction of curvature and having a tangent point 80 to the radial line 68. The tangent point 80 demarks two segments 82, 84 of the grooves 60C. A first segment 82 extends from the initial end 62C to the tangent point 80 and a second segment 84 extends from the tangent point 80 to the terminal end 64C. The curvatures of the segments 82, 84 are indicated by angles θ₂ and θ₃, respectively. Moving along the grooves 60C toward the tangent point 80 from the initial end 62C, θ₂ decreases. Moving along the grooves 60C away from the tangent point 80 from the terminal end 64C, θ₃ increases. Thus, θ₂ is greater than zero degrees and less than 90 degrees relative to the radial line 68 and θ₃ is greater than 90 degrees and less than 180 degrees relative to the radial line 68. The first segment 82 induces fluid flow from the initial end 62C to the tangent point 80 in the manner described above with reference to Figure 3. The fluid flow along the first segment 82 is represented by an arrow 86 during a direction of rotation ω. The second segment 84 curves away from the radial line 68 so that the segment 84 is oriented to avoid intersecting the center C_{pad}. In operation, the second segment 84 induces fluid to flow in the direction of the arrows 88. As a result, fluid flows inwardly (arrow 86) toward the tangent point 80 along the first segment 82 and outwardly (arrow 88) toward the tangent point 80 along the second segment 84. The resulting fluid flow through the grooves 60C produces a concentration of fluid in the collection area 76C (shown with dashed lines).

In another embodiment, the grooves 60 may be of varying geometric construction to provide multiple separate, or one larger, slurry collection area. For example, Figure 6 shows a pad 45D combining the grooves 60A (described with reference to Figure 3) and grooves 60C (described with reference to Figure 5). Grooves 60A provide slurry to a central area of the pad 45D (as shown by the area 76A in Figure 3) and grooves 60C provide slurry to an annular area of the pad 45D (as shown by the area 76C in Figure 5). Thus, the combination of grooves 60A and 60C provides an aggregate slurry collection area 76D. Other variations are contemplated to control the distribution of slurry on the upper surface of the polishing pad 45.

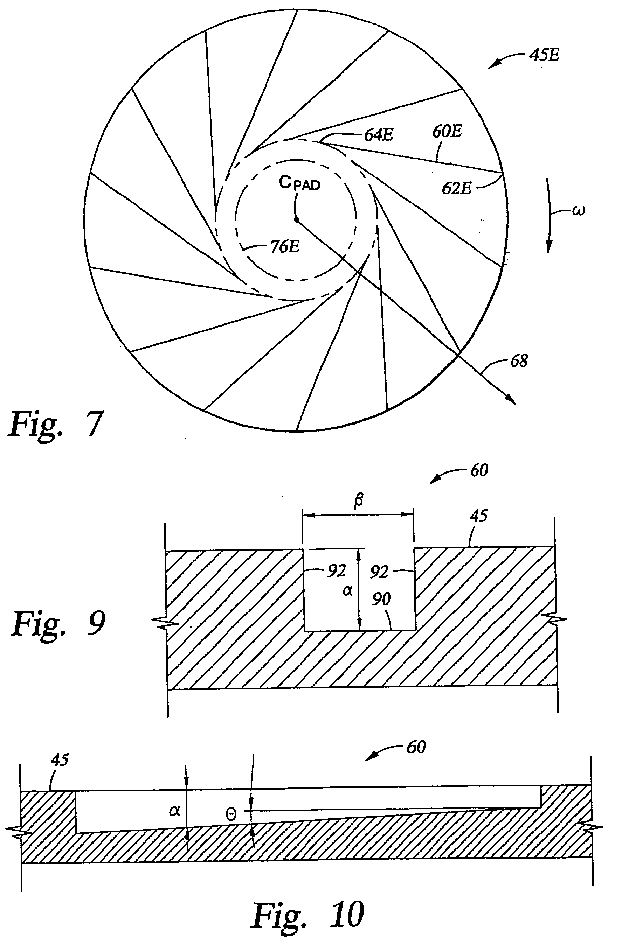

While Figures 3-6 show grooves 60A-C having a generally curvilinear shape, in other embodiments the grooves may be linear. For example, Figure 7 shows linear grooves 60E having an initial end 62E at the edge of the pad 45E and extending linearly inwardly to a terminal end 64E. The position of the terminal end 64E determines where the increased slurry concentration is formed during operation and is shown here by the slurry collection area 76E. In order to facilitate fluid flow from the initial end 62E to the terminal end 64E, the grooves 60E are oriented in a non-parallel relation relative to a radial line 68 extending from the initial end 62E of the grooves 60E to the center C_{pad} of the pad 45E. Accordingly, the grooves 60E are oriented to avoid intersecting the center C_{pad} of the pad 45E.

In another embodiment, the slurry distribution grooves 60 of the invention may be provided on a pad for use with a linear polishing assembly. Figure 8 shows a partial top view of the upper polishing surface of a linearly actuated pad 45F mounted on a pair of rollers 85 (shown by hidden lines). The rollers 85 are rotated by actuators (not shown) to drive the pad in the direction V, much like a conventional belt drive. The pad 45F includes V-shaped grooves 60F formed in the polishing surface. Each groove 60F includes a first segment 87A, a second segment 87B and an apex 89 where the first and second segments 87A-B interconnect. During operation, the pad 45F is actuated in the direction V so that the apex 89 points away from the direction of travel and the initial ends of each of the segments 87A-B lead the apex 89. Accordingly, slurry delivered to the surface of the pad 45F is induced to flow through the segments 87A-B toward the apex and then onto the upper surface of the pad 45F.

Figure 9 shows a cross sectional view of a groove 60. The groove 60 is defined by a bottom 90 and two sidewalls 92. While the sidewalls 92 are shown here as substantially parallel relative to one another, in other embodiments the sidewalls 92 may be any geometric shape including tapered, rounded, etc. The grooves 60 have a depth α and a width β. Although variable, in one embodiment the depth α is between about 30 mils and about 70 mils and the width β is between about 30 mils and about 100 mils when the total pad thickness is between about 50 mils and about 100 mils. Most preferably, the groove dimensions are about 50 x 50 mils on a pad having a thickness of about 80 mils.

One limitation on the maximum depth α of the grooves 60 is the impact on the rigidity of the pad. Increasing groove depth α can result in less pad rigidity. Because rigidity affects the polishing quality of the pad 45, the groove depth α should be adjusted to avoid loss of rigidity. On the other hand, the groove depth α should be sufficient to accommodate some degree of wear. Over time, continuous polishing will cause the pad 45 to wear resulting in a decrease in the overall pad thickness and groove depth α. Thus, in order to avoid premature replacement of the pad 45, the grooves 60 are sized to allow a sufficient lifetime. The particular groove depth α is dependent on other pad characteristics, *e.g.*, pad composition and construction, which affect the modulus of elasticity.

While the depth a is preferably constant along the length of the grooves 60, the invention contemplates having tapered or sloped grooves. The angle of inclination can facilitate slurry delivery control to a particular area of the pad 45 as determined by the direction of the inclination. For example, the grooves 60 may have an inclination causing the grooves 60 to become deeper toward the center of the pad 45 or, alternatively, deeper toward the edge of the pad 45. Figure 10 is a cross section of a tapered groove 60 taken along the length of the groove 60. As shown, the groove 60 has an inclination angle θ. In one embodiment, the groove 60 may have an inclination angle θ between about 1 degree and about 0.1 degrees. Because the pad 45 is disposed substantially horizontally during operation the increasing groove depth motivates the flow of fluid toward the center C_{pad} under the influence of gravity. In another embodiment, the grooves 60 may have varying and opposite angles of inclination so that well areas are formed along the length of the grooves 60 which act to collect a higher volume of slurry than at other areas of the grooves 60.

The foregoing embodiments are merely illustrative and the particular geometry of the grooves 60 is not limiting of the scope of the invention. Any groove design adapted to urge the slurry to a particular region of the pad 45 is contemplated by the invention.

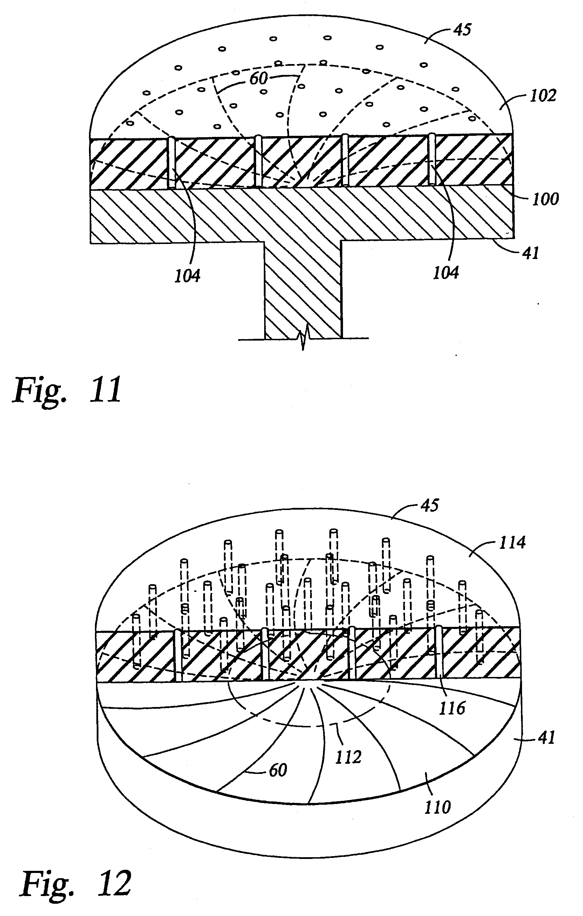

In another embodiment, the lower mounting surface of the pad 45 is patterned with slurry distribution/retaining grooves 60. Figure 11 shows a perspective cutaway view of the platen 41 having a perforated pad 45 disposed thereon. The pad 45 can be secured to the platen 41 by an adhesive, such as a pressure sensitive adhesive (PSA). The grooves 60 formed on the mounting surface 100 of the pad 45 may be of any geometry and orientation to achieve desired slurry/fluid flow. Accordingly, the grooves 60 are adapted to cause slurry flow from any point along the grooves 60 inwardly to a slurry collection area as determined by the particular groove structure.

The delivery of the slurry onto the upper polishing surface of a pad 45 is facilitated by pores or holes 104 formed in the pad 45. A plurality of pores or holes 104 formed in the pad 45 extend from the lower mounting surface 100 of the pad 45 to the upper polishing surface 102 of the pad 45, thereby providing fluid communication therebetween. The pad 45 shown in Figure 11 provides a substantially uniform distribution of pores 104. However, in another embodiment, the location of the pores 104 may be limited to the location of the slurry collection area to further control delivery of the slurry to a defined area. During operation, the slurry is flowed through the grooves 60 due to the rotation of the platen 41. As slurry accumulates at the slurry collection area, the increasing fluid pressure in the grooves 60 eventually forces slurry upward through the pores 104 and then onto the upper polishing surface 102 of the pad 45.

In another embodiment, the mounting surface of the platen 41 is patterned with slurry distribution/retaining grooves 60. Figure 12 shows a perspective cutaway view of the platen 41 having a perforated pad 45 disposed thereon. Grooves 60 formed on the pad mounting surface 110 of the platen 41 are similar in geometry and orientation to the grooves 60A described above with reference to Figure 3. However, the grooves 60 may alternatively be any embodiment adapted to deliver slurry/fluid flow to a desired location on the pad 45.

The grooves 60 are adapted to cause slurry flow from any point along the grooves 60 inwardly to a slurry collection area 112 on the platen 41 and then onto the upper polishing surface 114 of the pad 45. As described with regard to Figure 11, delivery of the slurry onto the upper polishing surface 114 is facilitated by pores 116 formed in the pad 45 which couple the grooves 60 to the upper polishing surface 114. One perforated pad which may be used to advantage is the IC 1000 available from Rodel, Inc. During operation, the slurry is flowed through the grooves 60 due to the rotation of the platen 41. As slurry accumulates at the slurry collection area 112, the increasing fluid pressure in the grooves 60 eventually forces slurry upward through the pores 116 and then onto the upper polishing surface 114 of the pad 45.

The embodiments shown in Figures 11 and 12 are believed to be effective in avoiding loss of polishing uniformity due to the presence of grooves on the polishing surface of the pad 45. Where the area of the polishing surface of the pad 45 occupied by grooves is too great, the ability of the pad 45 to uniformly polish a substrate is compromised. Accordingly, providing grooves on the mounting surface of the pad 45 and/or the mounting surface of the platen 41 allows the upper polishing surface of the pad 45 to be relatively planar. However, in other embodiments, both the upper polishing surface and the lower mounting surface are patterned with the grooves of the invention. In still other embodiments, both the upper polishing surface of the pad 45 and the mounting surface of the platen 41 are patterned with the grooves of the invention.

Where perforated polishing pads are used in combination with grooves 60 on the lower mounting surface of the pad 45 and/or the upper mounting surface of the platen 41, the grooves 60 preferably extend to the edge of the pad 45. Thus, the grooves 60 provide pathways between the platen 41 and the polishing pad 45 which vent to the environment of the pad/platen assembly. Where the grooves 60 are isolated from the environment, such as where the grooves 60 comprise concentric circles enclosed at the bottom by a platen, a partial vacuum condition may be created in the grooves as a substrate is urged against the polishing pad making subsequent removal of the substrate from the polishing pad more difficult. Although the pores in the pad 45 allow fluid communication between the grooves 60 and the ambience, the relatively small size of the pores may prevent quick stabilization of the pressure in the grooves relative to ambient conditions. By constructing open-ended grooves 60, the grooves 60 remain at equal pressure to the ambient environment, allowing easy removal of the substrate from the polishing pad 45 where a perforated pad is employed. In addition, the open-ended grooves 60 may also facilitate removal of the polishing pad 45 from the platen 41.

It is to be understood that terms such as top, bottom, upper, lower and the like, are relative terms and are not intended to be limiting. Other configurations are contemplated where a substrate can be handled in different orientations.

## Claims

1. An apparatus, comprising a semiconductor polishing device having a first surface defining at least one non-intersecting fluid retaining groove at least a portion of which is oriented at an angle relative to a radial line originating at a center of the semiconductor polishing device, wherein the non-intersecting fluid retaining groove is adapted to flow a fluid inwardly toward a center portion of the semiconductor polishing device.

2. The apparatus of claim 1, wherein the semiconductor polishing device is one of a polishing pad and a platen.

3. The apparatus of claim 1, wherein the depth of the non-intersecting fluid retaining groove changes along a length of the non-intersecting fluid retaining groove.

4. The apparatus of claim 1, wherein the non-intersecting fluid retaining groove has a first portion and a second portion having a same direction of curvature and defining a tangent point to the radial line.

5. The apparatus of claim 1, wherein the non-intersecting fluid retaining groove is oriented in a direction of rotation moving at an increasing radius from a first end of the grooves to a second end of the grooves.

6. The apparatus of claim 1, wherein the non-intersecting fluid retaining groove is oriented in a direction of rotation moving at an increasing radius along a length of the non-intersecting fluid retaining groove.

7. The apparatus of claim 1, wherein the non-intersecting fluid retaining groove is selected from arcuate grooves, linear grooves, and any combination thereof.

8. The apparatus of claim 1, wherein the non-intersecting fluid retaining groove extends from the center portion of the semiconductor polishing device to an edge of the semiconductor polishing device and wherein no point of the non-intersecting fluid retaining groove is tangent to the radial line.

9. The apparatus of claim 1, wherein the semiconductor polishing device is adapted for use with a rotary polisher.

10. The apparatus of claim 1, wherein the semiconductor polishing device is adapted for use with a linear polisher.

11. The apparatus of claim 1, wherein the semiconductor polishing device is a polishing pad and the first surface is a polishing surface.

12. The apparatus of claim 1, wherein the semiconductor polishing device is a platen and the first surface is a polishing pad mounting surface.

13. The apparatus of claim 1, wherein the semiconductor polishing device is a platen and the first surface is a polishing pad mounting surface having a perforated pad disposed thereon, wherein a plurality of perforations formed in the perforated pad couple the non-intersecting fluid retaining groove with a polishing surface of the perforated pad.

14. A substrate polishing pad, comprising:
(a) a polishing surface on a first side of the substrate polishing pad; and
(b) a mounting surface on a second side of the substrate polishing pad; wherein at least one of the polishing surface and the mounting surface has a plurality of non-intersecting fluid retaining grooves formed therein, wherein the grooves are disposed so that upon a given direction of movement of the substrate polishing pad a fluid disposed in the grooves is urged to flow from an outer portion toward a center portion of the substrate polishing pad.

15. The substrate polishing pad of claim 14, wherein the one or more fluid retaining grooves extend from the center portion of the substrate polishing pad to an edge of the substrate polishing pad and wherein no point of the grooves is tangent to a radial line extending from a center to the substrate polishing pad.

16. The substrate polishing pad of claim 14, wherein the grooves are formed on the mounting surface and the substrate polishing pad comprises perforations extending between the polishing surface and the mounting surface.

17. The substrate polishing pad of claim 14, wherein the substrate polishing pad comprises polyurethane.

18. The substrate polishing pad of claim 14, wherein the substrate polishing pad is adapted for use with a rotary polisher.

19. An apparatus for polishing a substrate, comprising:
(a) one or more rotatable platens;
(b) a motor coupled to the rotatable platens;
(c) one or more polishing heads rotatably mounted in facing relation to the rotatable platens; and
(d) a polishing pad disposed on each of the rotatable platens,
wherein at least one of the rotatable platens and the polishing pads comprise a plurality of non-intersecting fluid retaining grooves formed on a first surface thereof and wherein at least a portion of the grooves are disposed at an angle to a radial line extending from a center of the first surface and are adapted to flow a fluid inwardly from an outer portion to a center portion of the first surface.

20. The apparatus of claim 19, wherein the plurality of non-intersecting fluid retaining grooves comprise a plurality of arcuate grooves extending from the center portion to the outer portion.

21. The apparatus of claim 19, wherein the plurality of non-intersecting fluid retaining grooves are selected from the group of arcuate grooves, linear grooves and any combination thereof.

22. The apparatus of claim 19, wherein the plurality of non-intersecting fluid retaining grooves is selected from the group of:
(a) arcuate grooves;
(b) linear grooves disposed in an angular relation to the radial line; and
(c) a combination of (a) and (b).

23. The apparatus of claim 19, wherein the first surface is a platen mounting surface of the polishing pad in mating abutment with a pad mounting surface of the platen and further comprising a plurality of holes formed through the polishing pad and coupling the plurality of non-intersecting fluid retaining grooves with a polishing surface of the polishing pad.

24. The apparatus of claim 19, wherein the first surface is a pad mounting surface of the platen in mating abutment with a platen mounting surface of the polishing pad and further comprising a plurality of holes formed through the polishing pad and coupling the plurality of non-intersecting fluid retaining grooves with a polishing surface of the polishing pad.

25. The apparatus of claim 19, wherein the plurality of non-intersecting fluid retaining grooves is selected from the group of:
(a) arcuate grooves;
(b) linear grooves disposed in non-parallel relation to a radial line extending from a center of the polishing pad or platen; and
(c) a combination of (a) and (b).

26. The apparatus of claim 19, wherein the plurality of non-intersecting fluid retaining grooves comprise a first portion oriented at a first angle greater than 0 degrees and less than 90 degrees relative to the radial line and a second portion oriented at a second angle greater than 90 degrees and less than 180 degrees relative to the radial line.

27. The apparatus of claim 26, wherein the first and second angles vary along their respective lengths.

28. A rotatable platen for a polishing system, comprising a patterned pad mounting surface forming a plurality of non-intersecting fluid retaining grooves each having a portion oriented at an angle relative to a radial line originating at a center of the pad, the portion adapted to flow a fluid inwardly from a perimeter portion to a center portion of the platen during rotation of the platen.

29. The rotatable platen of claim 28, wherein the plurality of non-intersecting fluid retaining grooves is selected from the group of:
(a) arcuate grooves;
(b) linear grooves disposed in angular relation to the radial line; and
(c) a combination of (a) and (b).

30. The rotatable platen of claim 28, wherein a polishing pad is mounted on the pad mounting surface so that the polishing pad and the plurality of non-intersecting fluid retaining grooves form fluid passageways between the polishing pad and the platen.

31. The rotatable platen of claim 28, wherein the rotatable platen is part of a chemical mechanical polishing system.
